# EUROPÄISCHE PATENTSCHRIFT

(11) **EP 2 326 158 B1**
(45) Veröffentlichungstag und Bekanntmachung des Hinweises auf die Patenterteilung: **27.07.2016**
(21) Anmeldenummer: 10010602.0
(22) Anmeldetag: 24.09.2010
(51) Int. Cl.: H05K 7/20

(54) **Geräteschrank**
Equipment locker
Armoire pour appareils

(30) Priorität: 18.11.2009 DE 202009015795 U
(43) Veröffentlichungstag der Anmeldung: 25.05.2011
(73) Patentinhaber: Knürr GmbH, 94424 Arnstorf (DE)
(72) Erfinder: Bretschneider, Rainer, 01662 Meissen (DE); Beisig, Gunther, 01662 Meissen (DE); Ebermann, Heiko, 01109 Dresden (DE)
(74) Vertreter: Heim, Florian Andreas

(56) Entgegenhaltungen:
- WO-A2-2006/133589
- DE-A1- 19 954 572
- DE-C1- 19 709 145
- DE-U1- 9 110 572

## Beschreibung

Die Erfindung betrifft einen Geräteschrank mit einem Aufnahmeraum für elektronische Bauelemente und mit einem Wärmetauscher gemäß dem Oberbegriff des Anspruchs 1.

Die Erfindung ist insbesondere für Outdoor-Schaltschränke der Netzwerktechnik geeignet, wobei der Begriff elektronische Bauelemente elektronische Geräte, Baugruppen und Moduleinheiten und dergleichen umfassen soll.

Als Wärmetauscher wird ein Luft-Luft-Wärmetauscher eingesetzt. Luft-Luft-Wärmetauscher arbeiten in der Regel mit Kanalwärmeübertragern beziehungsweise Rekuperatoren, welche voneinander getrennte Luftkanäle für einen Innenluftstrom und einen Außenluftstrom aufweisen und beispielsweise durch Kanalplatten gebildet sein können. Je nach Anordnung der Innen- und Außenluftkanäle unterscheidet man zwischen Gleichstrom-, Gegenstrom- und Kreuzstrom-Wärmetauschern.

Wärmetauscher für die indirekte Wärmeübertragung von Geräteschränken weisen neben dem Wärmeübertrager mit Kanälen für einen Innenluftstrom und Kanälen für einen Außenluftstrom Gebläse beziehungsweise Lüfter für den Innen- und Außenluftstrom und elektrotechnische Komponenten zur Stromzuführung und Regelung der Innen- und Außenluftströme auf. Als Gebläse werden bei den bekannten Luft-Luft-Wärmetauschern in der Regel Radialventilatoren, jedoch auch Axial- und Diagonallüfter eingesetzt. Der Wärmeübertrager kann dabei auf der Saugseite als auch auf der Druckseite des Ventilators beziehungsweise der Ventilatoren angeordnet werden.

Es ist bekannt, einen Wärmetauscher in eine front- oder rückseitige Tür beziehungsweise in eine Rückwand oder in eine Seitenwand oder auch auf der Deckfläche eines Geräteschranks anzuordnen. Bei Verwendung von Radialventilatoren, welche wegen des besseren Verhältnisses von Druckabfall und Volumenstrom vorteilhaft sind, er folgt ein Einbau derart, dass die Ventilatorachse 90° zur Kanalebene angeordnet ist (DE 197 09 145 C1, WO 2006/133589 A2).

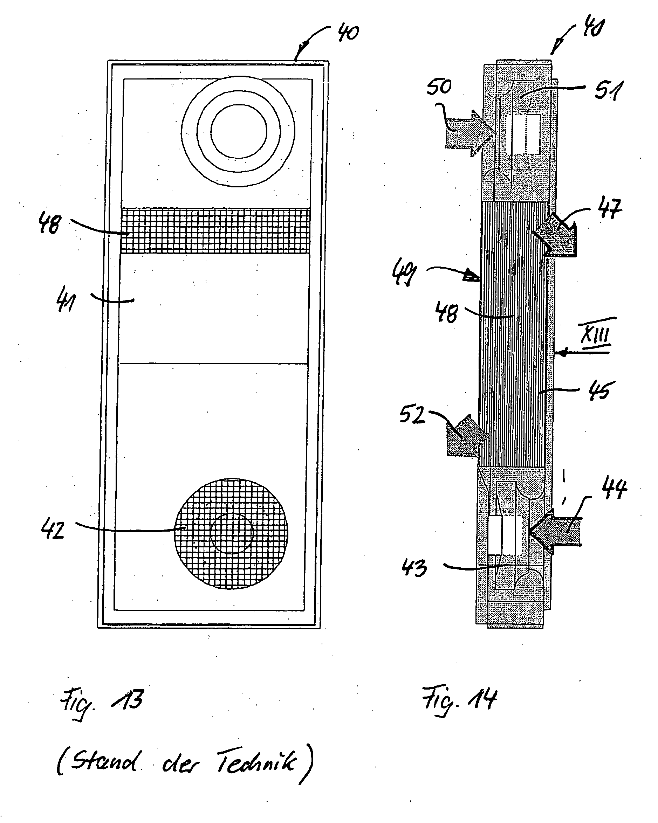

Eine bekannte Anordnung eines Luft-Luft-Wärmetauschers in einer Tür eines Geräteschrankes geht aus den Fig. 13 und 14 hervor. Die Tür 40 weist in einer Innenfläche 41, welche einem Aufnahmeraum eines nicht dargestellten Geräteschrankes zugewandt ist, eine untere Öffnung 42 auf, über welche mit Hilfe eines Radialventilators 43 Kaltluft 44 aus der Umgebung angesaugt und durch die Außenluftkanäle 45 eines Wärmeübertragers 49 nach einer 90°-Umlenkung gedrückt wird. Der Austritt der im Wärmeübertrager 49 erwärmten Außenluft 47 erfolgt über Öffnungen 48 in oberen Bereichen der Außenluftkanäle 45. Die Außenluftkanäle 45 sind ebenso wie die alternierend angeordneten Innenluftkanäle 46 des Wärmeübertragers 49 in Fig. 14 nur schematisch dargestellt.

Die Zuführung der im Aufnahmeraum des Geräteschrankes (nicht dargestellt) erwärmten Innenluft 50 erfolgt ebenfalls mit Hilfe eines Radialventilators 51, welcher in einem oberen Bereich der Wärmetauschertür 40 angeordnet ist. Die angesaugte, erwärmte Innenluft 50 wird nach einer 90°-Umlenkung durch die Innenluftkanäle 46 des Wärmeübertragers 49 gedrückt und gelangt als gekühlte Innenluft 52 über Öffnungen im unteren Bereich des Wärmeübertragers 49 wieder zurück in den Aufnahmeraum des Geräteschrankes.

Der in den Fig. 13 und 14 gezeigte Türeinbau eines Luft-Luft-Wärmetauschers mit Radialventilatoren setzt eine ausreichende Bauhöhe der Tür voraus, um die Druckverluste aufgrund der relativ hohen Austrittsgeschwindigkeit aus dem Radialventilator durch eine geeignete weiterführende Kanalgestaltung zu minimieren.

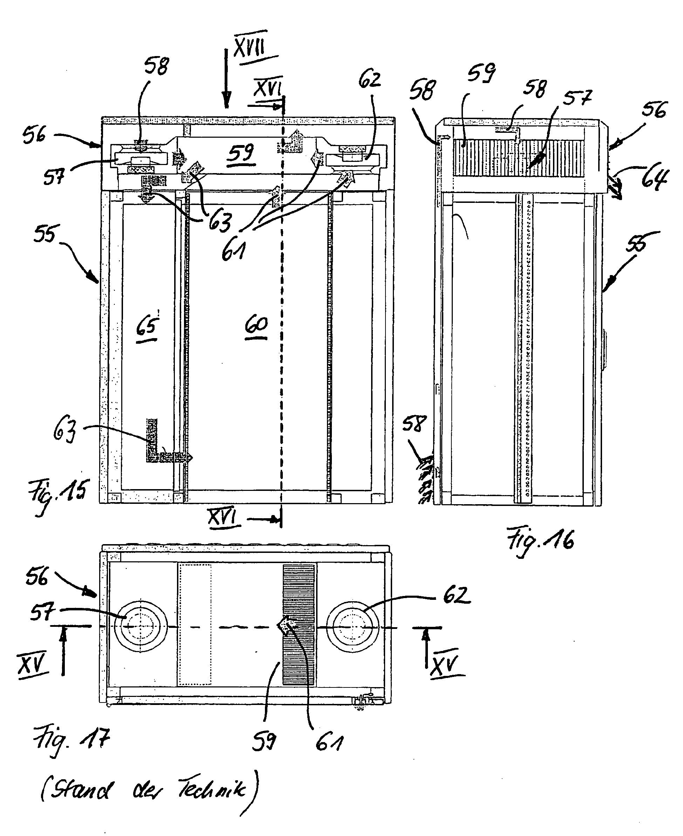

Ein Dach-Wärmetauscher bisheriger Ausführung ist in den Fig. 15 bis 17 dargestellt, wobei Fig. 15 einen frontseitigen Längsschnitt nach Linie XV-XV in Fig. 17, Fig. 16 einen Längsschnitt gemäß der Linie XVI-XVI in Fig. 15 und Fig. 17 eine Draufsicht gemäß Pfeil XVII in Fig. 15, jedoch ohne Dach, zeigt.

Ein Geräteschrank 55 mit einem Aufnahmeraum 60 für elektronische Bauteile und dergleichen (nicht dargestellt) ist zur Abführung der Verlustwärme der elektronischen Bauelemente mit einem Dach-Wärmetauscher 56 versehen. Der Dach-Wärmetauscher 56 weist einen Axialventilator 57 auf, welcher Kaltluft 58 aus der Umgebung ansaugt und in einen Wärmeübertrager 59 mit entsprechend ausgebildeten Kalt- beziehungsweise Außenluftkanälen und Innenluftkanälen drückt. Die mit der Verlustwärme beaufschlagte Innenluft 61 wird von einem Axialventilator 62 angesaugt und gelangt in die Innenluftkanäle des Wärmeübertragers 59, wo die Verlustwärme an die Außenluft abgegeben wird, welche als erwärmte Außenluft 64 in die Umgebung des Geräteschrankes 55 gelangt. Die entwärmte beziehungsweise abgekühlte Innenluft 63 wird über einen vertikalen Luftkanal 65 in einem bodenseitigen Bereich dem Aufnahmeraum 60 des Geräteschrankes 55 wieder zugeführt.

Nachteilig bei dem bekannten Geräteschrank mit einem Dach-Wärmetauscher gemäß den Fig. 15 bis 17 sind die erforderlichen Mindestlängen des Wärmetauschers aufgrund der erforderlichen Länge des Wärmeübertragers sowie der Durchmesser der Axialventilatoren und der erforderlichen Freiräume für den Luftstrom. Bei relativ geringen Bauhöhen können dadurch Leistungserhöhungen, welche notwendig werden, nicht realisiert werden.

Bei Dach-Wärmetauschern für Geräteschränke mit geringen Gehäusebreiten kann zudem eine Baubreite erforderlich werden, welche für die Funktionalität an sich nicht benötigt wird. Bekannte Wärmetauscher mit Axialventilatoren arbeiten drückend. Damit wird die im Wärmeübertrager abgekühlte Innenluft mit einer durch den inneren Druckverlust im Wärmeübertrager verringerten kinetischen Energie dem Aufnahmeraum des Geräteschrankes wieder zugeführt. Die Austrittsöffnung liegt in aller Regel aufgrund der Geometrie der Anordnung im mittleren Drittel des Schrankes. Das führt insbesondere bei quer angeordneten Moduleinheiten und Geräten dazu, dass der Innenluftstrom Prallwirkungen ausgesetzt wird. Zusammen mit einer relativ geringen kinetischen Energie trägt dies dazu bei, dass die abgekühlte Innenluft nur in einem oberen Schrankbereich wirksam wird und durch Kurzschlusswirkung auch wieder in den angesaugten Innenluftstrom gelangen kann, so dass die Kühlwirkung wesentlich geringer ist.

Um diesen Nachteil zu kompensieren, müssen zwischen dem Dach-Wärmetauscher und der Schrankdecke Verteilkanäle oder vertikale Luftkanäle eingebaut werden. Diese rufen jedoch ebenfalls zusätzliche Druckverluste hervor. Die Anwendung von Axial- oder auch Diagonalventilatoren ermöglicht nur den Ausgleich eines relativ geringen Druckverlustes im Wärmeübertrager durch die Ventilatoren. Aus diesem Grunde werden bei derartigen Anwendungen die Ventilatoren in Reihe hintereinander angeordnet, was zu hohen Kosten und Bauraumbedarf führt.

Der Erfindung liegt die **Aufgabe** zugrunde, Geräteschränke mit einem Wärmetauscher auszustatten, welcher eine außerordentlich verbesserte Schrankdurchströmung mit einer effizienten Abführung der Verlustwärme gewährleistet und gleichzeitig eine Verringerung von Bauhöhe beziehungsweise Baubreite der Geräteschränke in Bezug auf den Wärmetauscher ermöglicht, um den Anforderungen in Bezug auf die Standortgenehmigungen zu genügen.

Eine Grundidee der Erfindung kann darin gesehen werden, einen Luft-Luft-Wärmetauscher für Geräteschränke zu schaffen, welcher hinsichtlich Druckverlust und Bauraum optimiert ist und sowohl die erforderliche Abführung der Verlustwärme aus dem Geräteschrank gewährleistet als auch die notwendigen Abmessungen der Geräteschränke mit Wärmetauscher gewährleistet.

Gemäß der Erfindung wird die Durchströmung des Aufnahmeraums eines erfindungsgemäßen Geräteschrankes mittels gerichteter Luftaustritte und hoher kinetischer Energie verbessert und gleichzeitig die Umlenkfunktion innerhalb von Radiallüftern für unterschiedliche Applikationen des Luft-Luft-Wärmetauschers an Geräte- und Schaltschränken ausgenutzt.

Erfindungsgemäß weist ein Geräteschrank mit einem Aufnahmeraum für elektronische Bauelemente und mit einem Wärmetauscher, welcher einen Wärmeübertrager mit Kanälen für einen Innenluftstrom und einen Außenluftstrom sowie ein Gebläse für den Innenluftstrom und ein Gebläse für den Außenluftstrom aufweist, zumindest als Gebläse für den Innenluftstrom einen Radiallüfter auf, welcher, bezogen auf die Strömungsrichtung der Innenluft nach einem Wärmeübertrager des Wärmetauschers und mit seiner Saugseite beabstandet zu dem Wärmeübertrager derart angeordnet und dimensioniert ist, dass zwischen dem Wärmeübertrager und dem Radiallüfter ein Ansaugraum für einen gleichmäßigen Unterdruck in den Kanälen des Wärmeübertragers ausgebildet ist.

Erfindungsgemäß werden die Radiallüfter und der Wärmeübertrager so angeordnet, dass die Ansaugrichtung des Volumenstroms zum Lüfter parallel zu den Achsen der Kanäle des Wärmeübertragers verläuft. Der Radiallüfter für den Innenluftstrom ist somit derart angeordnet, dass seine Lüfterachse in Ansaugrichtung und mit einer gedachten Verlängerung der Lüfterachse axial oder parallel zu den Längsachsen der Innenluftkanäle des Wärmeübertragers ausgerichtet ist.

Der Ansaugraum für den Innenluftstrom, das heißt, für den im Wärmeübertrager abgekühlten Innenluftstrom, wird wärmeübertragerseitig von einer Austrittsebene des gekühlten Luftstroms aus dem Wärmeübertrager und lüfterseitig von einer Saugdüse des Radiallüfters begrenzt.

Es ist vorteilhaft, dass der Ansaugraum für den gekühlten Innenluftstrom Bestandteil des Gehäuses des Wärmetauschers beziehungsweise Wärmeübertragers sein kann. Die Luftaustrittsfläche des Wärmeübertragers wird dadurch nicht durch die sonst notwendigen Biegkanten verringert.

Besonders vorteilhaft ist es, wenn auch der Radiallüfter für den Innenluftstrom in das Gehäuse des Wärmeübertragers beziehungsweise Wärmetauschers integriert ist.

Der Wirkungsrad des erfindungsgemäßen Wärmetauschers für einen Geräteschrank wird weiter erhöht, wenn auch das Gebläse für den Außenluftstrom ein Radiallüfter ist, welcher, bezogen auf die Richtung des Außenluftstroms, nach dem Wärmeübertrager und unter Ausbildung eines Ansaugraumes für den im Wärmeübertrager erwärmten Außenluftstrom zwischen dem Wärmeübertrager und der Saugseite des Radiallüfters angeordnet ist.

Um auch hinsichtlich des Kaltluftstroms aus der Umgebung gerichtete Luftsaustritte zu erreichen, wird der Radiallüfter für den Außenluftstrom mit seiner Lüfterachse in Ansaugrichtung und mit einer gedachten Verlängerung der Lüfterachse axial und parallel zu den Längsachsen der Außenluftkanäle des Wärmeübertragers angeordnet. Der Wärmeübertrager weist bevorzugt Kanalplatten zur Ausbildung der Innenluft- und Außenluftkanäle auf und die Wärmeübertragung erfolgt vorzugsweise nach dem Gegenstromprinzip.

Ein wesentlicher Vorteil des erfindungsgemäßen Geräteschrankes beziehungsweise Wärmetauschers für einen Geräteschrank besteht darin, dass die Ursachen für Druckverluste beseitigt sind und damit der Wirkungsgrad des Wärmetauschers erhöht und ein klimatechnisch effizientes Kühlsystem erreicht wird. Die bei den bekannten Geräteschränken bisher notwendigen Luftverteilungs- und -führungskanäle, Leitbleche und dergleichen können entfallen was sich insbesondere bei den erfindungsgemäßen Geräteschränken mit Dach-Wärmetauschern vorteilhaft auswirkt. Die hier mögliche Verringerung von Bauraum ist mit einem geringeren Materialeinsatz je gekühlter Einheit verbunden und ermöglicht die Einhaltung von Minimalabmessungen für Standortgenehmigungen, da die Bauhöhe, Baubreite und/oder Bautiefe ohne Weiteres eingehalten werden können. Die vorteilhafte Integration des Ansaugraumes, insbesondere die für die im Kreislauf geführte Innenluft, in das Gehäuse des Wärmeübertragers ermöglicht zudem eine Kosteneinsparung, da ein separates Bauteil für die Druckbeaufschlagung des Wärmeübertragers in der bisher üblichen Bauweise nicht mehr erforderlich ist. Der Wegfall von Biegkanten, welche bei der bekannten Bauweise der Wärmeübertrager zur Versteifung und zur Bildung von Dichtflächen erforderlich ist, erhöht die wirksame Kanalquerschnittsfläche im Ansaugbereich und trägt damit ebenfalls zur Verbesserung der Kühlleistung bei.

Die Erfindung wird nachstehend anhand einer Figurenbeschreibung weiter erläutert. Es zeigen:
- Fig. 1 bis 4: einen erfindungsgemäßen Geräteschrank mit einem Dach-Wärmetauscher, wobei
Fig. 1 einen vertikalen Schnitt gemäß Linie I-I in Fig. 3,
Fig. 2 einen Längsschnitt gemäß Linie II-II in Fig. 1,
Fig. 3 einen horizontalen Schnitt gemäß Linie III-III in Fig. 1 und
Fig. 4 einen horizontalen Schnitt gemäß Fig. 3, jedoch ohne Dach, zeigt;
- Fig. 5 und 6: ein erfindungsgemäßes Wärmeübertrager-Gehäuse, wobei

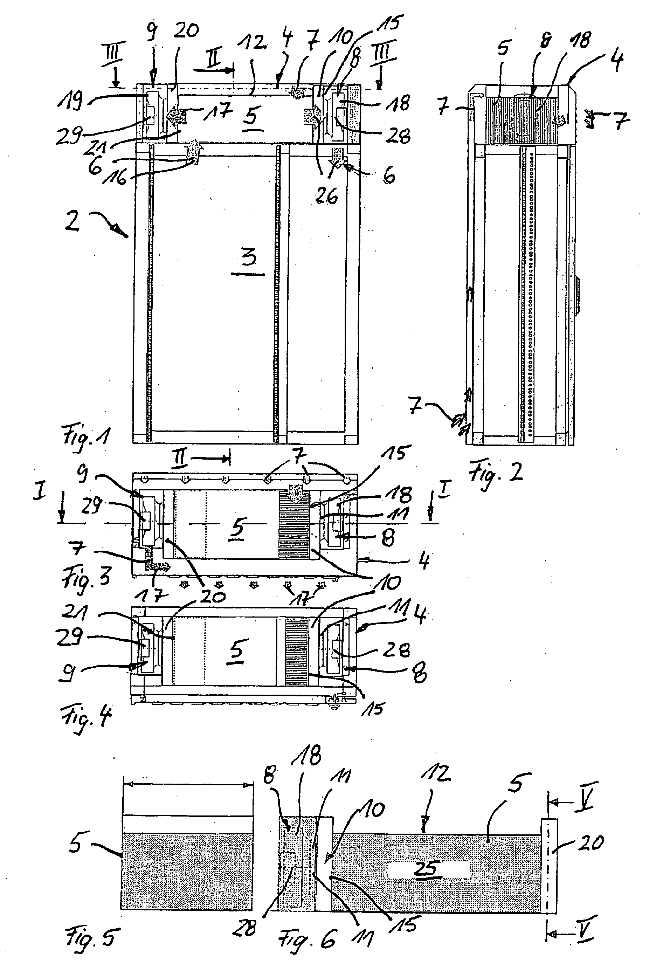

Fig. 5 einen Vertikalschnitt nach Linie V-V in Fig. 6 zeigt;

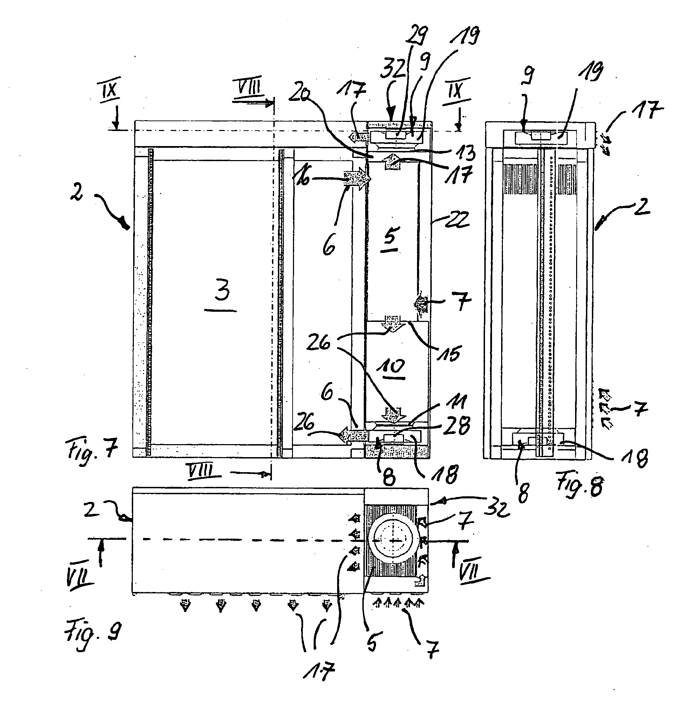

- Fig. 7 bis 9: einen erfindungsgemäßen Geräteschrank mit einem Seitenanbau-Wärmetauscher, wobei
Fig. 7 einen vertikalen Schnitt gemäß Linie VII-VII in Fig. 9,
Fig. 8 einen vertikalen Schnitt gemäß Linie VIII-VIII in Fig. 7, und
Fig. 9 einen horizontalen Schnitt gemäß Linie IX-IX in Fig. 7 zeigt;

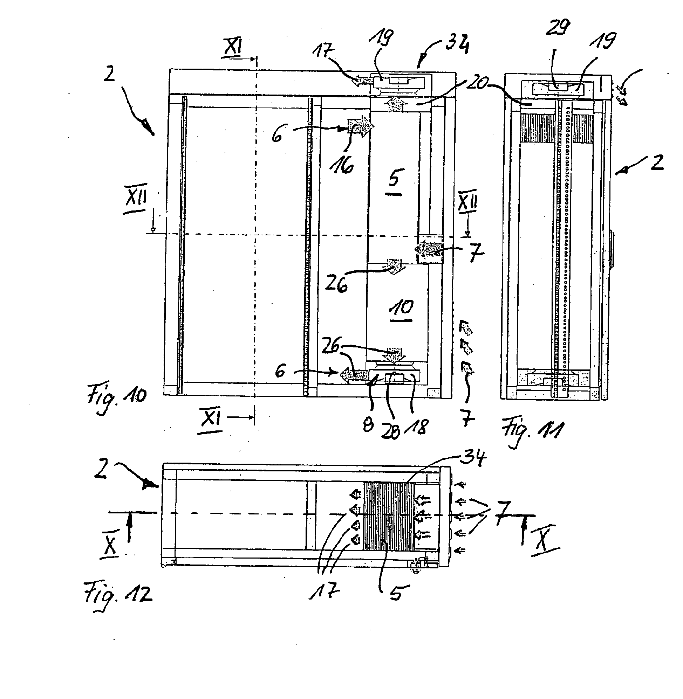

- Fig. 10 bis 12: einen erfindungsgemäßen Geräteschrank mit einem Seiteneinbau-Wärmetauscher, wobei
Fig. 10 einen vertikalen Schnitt gemäß Linie X-X in Fig. 12,
Fig. 11 einen vertikalen Schnitt gemäß Linie XI-XI in Fig. 10, und
Fig. 12 einen horizontalen Schnitt gemäß Linie XII-XII in Fig. 10 zeigt.

Im Gegensatz zu den vorgenannten Zeichnungsfiguren der Erfindung betreffen die
- Fig. 13 und 14: eine bekannte Geräteschrank-Wärmetauschertür und die
- Fig. 15 bis 17: einen bekannten Geräteschrank mit einem Dach-Wärmetauscher, welche im Stand der Technik beschrieben sind.

Der in den Fig. 1 bis 4 gezeigte Geräteschrank 2 weist oberhalb eines Aufnahmeraums 3 für elektronische Baugruppen, Bauteile, Moduleinheiten und dergleichen (nicht dargestellt) einen Wärmetauscher 4 auf, welcher als Dach-Wärmetauscher ausgebildet und angeordnet ist und neben einem Wärmeübertrager 5 ein Gebläse 8 für einen Innenluftstrom 6 und ein Gebläse 9 für einen Außenluftstrom 7 aufweist.

Der Wärmeübertrager 5 besteht aus Kanalplatten 25 (siehe auch Fig. 5 und 6), welche parallel zueinander angeordnet sind und Kanäle für einen Innenluftstrom und einen Außenluftstrom für eine Wärmeübertragung bilden.

Als Gebläse 8 für den im Kreislauf geführten Innenluftstrom 6 ist ein Radiallüfter 18 und als Gebläse 9 für den Außenluftstrom ist ein Radiallüfter 19 in Seitenbereichen des Dach-Wärmetauschers 4 beziehungsweise des Geräteschrankes 2 angeordnet. Wie insbesondere die Fig. 1, 3 und 4 zeigen, ist sowohl der Radiallüfter 18 für den Innenluftstrom 6 als auch der Radiallüfter 19 für den Außenluftstrom 7, jeweils bezogen auf die Strömungsrichtung des Innenluftstroms 6 beziehungsweise Außenluftstroms 7, nach dem Wärmeübertrager 5 und jeweils mit der Saugseite zum Wärmeübertrager 5 gerichtet angeordnet, so dass die Lüfterachse 28 des Radiallüfters 18 für den Innenluftstrom 6 und auch die Lüfterachse 29 des Radiallüfters 19 für den Außenluftstrom 9 axial beziehungsweise parallel zu den Längsachsen der Innenluftkanäle und Außenluftkanäle des Wärmeübertragers 5 verlaufen. Damit wird ein gerichteter Innenluftaustritt geschaffen, welcher den Druckverlust verringert und die Durchströmung des Schrankes und damit die Abführung der Verlustwärme aus dem Schrank 2 wesentlich verbessert.

Der Radiallüfter 18, welcher aus dem Aufnahmeraum 3 des Geräteschrankes 2 die mit der Verlustwärme beaufschlagte, erwärmte Innenluft 16 in den Wärmeübertrager 5 ansaugt, drückt die im Wärmeübertrager 5 abgekühlte Innenluft 26 unter Ausnutzung der 90°-Umlenkung im Radiallüfter 18 wieder in den Aufnahmeraum 3 zurück.

Ein ausreichend dimensionierter Ansaugraum 10 ist zwischen der Austrittsebene 15 des gekühlten Innenluftstroms 26 aus dem Wärmeübertrager 5 und der Saugseite des Radiallüfters 18, welcher eine Saugdüse 11 aufweist, begrenzt und mit Hilfe des Abstandes zwischen der Luftaustrittsebene 15 und der Saugdüse 11 kann ein gleichmäßiger Unterdruck in den Kanälen für die Innenluft im Wärmeübertrager 5 hergestellt werden.

Eine besonders kompakte Bauweise ergibt sich, wenn dem Außenluftstrom 7, welcher über bodenseitige Öffnungen des Geräteschrankes 2 (siehe Fig. 2) und einen

Außenluftkanal 23 dem Dach-Wärmetauscher 4 zugeführt wird, ebenfalls ein Radiallüfter 19 als Gebläse 9 zugeordnet wird und wenn die Saugseite dieses Radiallüfters 19 von einer Austrittsebene 21 der im Wärmeübertrager 5 erwärmten Außenluft 17 durch einen Ansaugraum 20 beabstandet ist. Der Ansaugraum 10 für die aus dem Wärmeübertrager 5 angesaugte, gekühlte Innenluft 26 und auch der Ansaugraum 20 für die im Wärmeübertrager 5 erwärmte Außenluft 17 sind im Ausführungsbeispiel der Fig. 1 bis 4 etwa gleich dimensioniert. Aus den Fig. 3 und 4 geht hervor, dass der Wärmeübertrager 5 nahezu zentral im Dachbereich des Geräteschrankes 2 beziehungsweise in einem Wärmetauschergehäuse 22 angeordnet ist.

Die Fig. 1 bis 4 zeigen einen erfindungsgemäßen Geräteschrank mit einem Dach-Wärmetauscher, welcher bei gleicher oder größerer Kühlleistung den Bauraumgewinn im Vergleich zum bekannten Dach-Wärmetauscher beziehungsweise Geräteschrank der Fig. 15 bis 17 ausweist. Insbesondere die Baubreite des bisherigen Geräteschrankes mit Dach-Wärmetauscher ist erheblich größer als bei dem erfindungsgemäßen Geräteschrank.

Die Fig. 5 und 6 zeigen die Anordnung des Wärmeübertragers 5, des Ansaugraums 10 für den Innenluftstrom 6 beziehungsweise den im Wärmeübertrager 5 entwärmten oder abgekühlten Innenluftstrom 26 (siehe auch Fig. 1) und den Radiallüfter 18, welcher den abgekühlten Innenluftstrom 26 nach einer 90°-Umlenkung wieder dem Aufnahmeraum eines Geräteschrankes (siehe Fig. 1) zuführt. Der Wärmeübertrager 5 mit einem, bezogen auf die Strömungsrichtung des Innenluftstroms 6 beziehungsweise 26, nach dem Wärmeübertrager 5 angeordneten Ansaugraum 10 und dem Radiallüfter 18 für den Innenluftstrom sind in einem Gehäuse 12 aufgenommen.

In Fig. 6 ist eine Kanalplatte 25 des Wärmeübertragers 5 gezeigt, und vorteilhafterweise werden die von den Kanalplatten 25 gebildeten Kanäle von der Innenluft und Außenluft im Gegenstromprinzip durchströmt. Wesentlich ist die Ausbildung des Ansaugraumes 10 zwischen der Saugdüse 11 des Radiallüfters 18 und der Austrittsebene 15 des Wärmeübertragers 5 sowie die axiale beziehungsweise parallele Ausrichtung der Längsachsen der Kanäle des Wärmeübertragers 5 zu der Lüfterachse 28 des Radiallüfters 18 beziehungsweise einer gedachten Verlängerung der Lüfterachse 28.

Die Fig. 7 bis 9 zeigen einen Geräteschrank 2 mit einem Seitenanbau-Wärmetauscher 32. Ein Vergleich mit dem bisher bekannten Geräteschrank der Fig. 15 bis 17 beweist die erreichte Minimierung der Abmessungen des Geräteschrankes 2 bei gleicher oder verbesserter Kühlwirkung des Seitenanbau-Wärmetauschers 32. Der Seitenanbau-Wärmetauscher 32 weist ein Gehäuse 22 auf, in dessen oberen Bereich der Wärmeübertrager 5 angeordnet ist, und Kanäle für die Innenluft 6 und Außenluft 7, welche vertikal ausgerichtet sind und damit parallel zu der Lüfterachse 28 des bodenseitig angeordneten Radiallüfters 18 für den Innenluftstrom 6 und axial beziehungsweise parallel zu dem in einem oberen Dachbereich angeordneten Radiallüfter 19 für den Außenluftstrom 7 und dessen vertikal ausgerichteten Lüfterachse 29. Die Lüfterachsen 28 und 29 der zwei Radiallüfter 18 und 19 sind wie die Längsachsen der Innen- und Außenluftkanäle des Wärmeübertragers 5 vertikal ausgerichtet. Die Außenluft 7 gelangt über untere Öffnungen im Geräteschrank 2 (Fig. 8 und 9) in den Wärmeübertrager 5 und wird über einen Ansaugraum 20, welcher zwischen dem Wärmeübertrager 5 und einer Saugdüse 13 des Radiallüfters 19 ausgebildet ist, danach als erwärmter Außenluftstrom 17 wieder in die Umgebung des Geräteschrankes 2 abgeführt.

Insbesondere Fig. 7 zeigt, dass der Ansaugraum 10 unterhalb des Wärmeübertragers 5, welcher zwischen einer Austrittsebene 15 des Wärmeübertragers 5 für die im Wärmeübertrager 5 abgekühlte Innenluft 26 und der Saugdüse 11 des Radiallüfters 18 für den Innenluftstrom 6 beziehungsweise für den gekühlten Innenluftstrom 26 ausgebildet ist, wesentlich größer als der deckenseitige Ansaugraum 20 für den Außenluftstrom 7 dimensioniert ist.

Die Fig. 8 und 9 verdeutlichen ebenfalls die Anordnung der Radiallüfter 18, 19 sowie die Kaltluftführung 7, 17 im Geräteschrank 2 und in dem Seitenanbau-Wärmetauscher 32.

In den Fig. 10 bis 12 ist ein Seiteneinbau-Wärmetauscher 34 in einem Geräteschrank 2 gezeigt. Die Änderungen zum Seitenanbau-Wärmetauscher 32 und den Geräteschrank 2 der Fig. 7 bis 9 betreffen insbesondere die Zuführung der Außenluft, das heißt, den Außenluftstrom 7 bis zum Wärmeübertrager 5. Die mit den Fig. 7 bis 9 übereinstimmenden Bauteile sind wieder mit identischen Bezugszeichen versehen.

Ein Vergleich des Geräteschrankes 2 der Fig. 7 bis 9 mit einem Seitenanbau-Wärmetauscher 32 und des Geräteschrankes 2 der Fig. 10 bis 12 mit einem Seiteneinbau-Wärmetauscher 34 mit dem bekannten Geräteschrank der Fig. 15 bis 17 zeigt deutlich die verringerte Bauhöhe und Baubreite der erfindungsgemäßen Geräteschränke.

## Patentansprüche

1. Geräteschrank
mit einem Aufnahmeraum (3) für elektronische Bauelemente und mit einem Wärmetauscher (4), welcher einen Wärmeübertrager (5) mit parallel zueinander angeordneten Kanalplatten zur Ausbildung von Kanälen für einen Innenluftstrom (6) und einen Außenluftstrom (7) sowie ein Gebläse (8) für den Innenluftstrom (6) und ein Gebläse (9) für den Außenluftstrom (7) aufweist, wobei der Innenluftstrom (6) mit Hilfe des Innenluftgebläses (8) im Kreislauf durch den Aufnahmeraum (3) und den Wärmetauscher (4) geführt und der mit der Verlustwärme der elektronischen Bauelemente beaufschlagte, erwärmte Innenluftstrom (16) im Wärmeübertrager (5) durch den Außenluftstrom (7) entwärmbar und als gekühlter Innenluftstrom (26) dem Aufnahmeraum (3) wieder zuführbar ist,
wobei
das Gebläse (8) für den Innenluftstrom (6) ein Radiallüfter (18) ist, welcher, bezogen auf die Richtung des Innenluftstroms (6), nach dem Wärmeübertrager (5) und mit seiner Saugseite beabstandet zu dem Wärmeübertrager (5) derart angeordnet und dimensioniert ist, dass zwischen dem Wärmeübertrager (5) und dem Radiallüfter (18) ein Ansaugraum (10) für einen gleichmäßigen Unterdruck in den Innenluftkanälen des Wärmeübertragers (5) ausgebildet ist, **dadurch gekennzeichnet, dass** der Radiallüfter (18) für den Innenluftstrom (6) mit seiner Lüfterachse (28) in Ansaugrichtung und mit einer gedachten Verlängerung der Lüfterachse (28) parallel zu den Längsachsen der Innenluftkanäle des Wärmeübertragers (5) angeordnet ist.

2. Geräteschrank nach Anspruch 1,
**dadurch gekennzeichnet,**
**dass** der Ansaugraum (10) für den gekühlten Innenluftstrom (26) auf der Seite des Wärmeübertragers (5) von einer Austrittsebene (15) des gekühlten Innenluftstroms (26) aus dem Wärmeübertrager (5) und lüfterseitig von einer Saugdüse (11) des Radiallüfters (18) begrenzt ist.

3. Geräteschrank nach einem der Ansprüche 1 oder 2,
**dadurch gekennzeichnet,**
**dass** der Ansaugraum (10) für den gekühlten Innenluftstrom (26) in ein Gehäuse (12) des Wärmetauschers (4) integriert ist, in welches auch der Radiallüfter (18) für den Innenluftstrom (6) anordenbar ist.

4. Geräteschrank nach einem der vorhergehenden Ansprüche,
**dadurch gekennzeichnet,**
**dass** das Gebläse (9) für den Außenluftstrom (7) ein Radiallüfter (19) ist, welcher, bezogen auf die Richtung des Außenluftstroms (7), nach dem Wärmeübertrager (5) und unter Ausbildung eines Ansaugraums (20) für den im Wärmeübertrager (5) erwärmten Außenluftstrom (17) zwischen dem Wärmeübertrager (5) und der Saugseite des Radiallüfters (19) angeordnet ist.

5. Geräteschrank nach Anspruch 4,
**dadurch gekennzeichnet,**
**dass** der Radiallüfter (19) für den Außenluftstrom (7) mit seiner Lüfterachse (29) in Ansaugrichtung und mit einer gedachten Verlängerung der Lüfterachse (29) parallel zu den Längsachsen der Außenluftkanäle des Wärmeübertragers (5) angeordnet ist.

6. Geräteschrank nach Anspruch 4 oder 5,
**dadurch gekennzeichnet,**
**dass** der Ansaugraum (20) für den im Wärmeübertrager (5) erwärmten Außenluftstrom (17) auf der Seite des Wärmeübertragers (5) von einer Austrittsebene der im Wärmeübertrager (5) erwärmten Außenluft (17) und lüfterseitig von einer Saugdüse (13) des Radiallüfters (19) begrenzt ist.

7. Geräteschrank nach einem der vorhergehenden Ansprüche,
**dadurch gekennzeichnet,**
**dass** der Wärmetauscher (4) ein Dach-Wärmetauscher ist mit einem Wärmeübertrager (5), welcher horizontal angeordnete Innenluft- und Außenluftkanäle aufweist, sowie mit Radiallüftern (18, 19) für den Innenluftstrom (6) und für den Außenluftstrom (7), welche unter Ausbildung eines Ansaugraums (10) für den im Wärmeübertrager (5) abgekühlten Innenluftstrom (26) und eines Ansaugraums (20) für den im Wärmeübertrager (5) erwärmten Außentuftstrom (17) jeweils beabstandet zu dem Wärmeübertrager (5) in einander gegenüberliegenden Seitenbereichen des Geräteschrankes (2) oder in Seitenbereichen des Dachs des Geräteschranks (2) angeordnet sind. (Fig. 1 bis 4)

8. Geräteschrank nach Anspruch 7,
**dadurch gekennzeichnet,**
**dass** der Ansaugraum (10) für den im Wärmeübertrager (5) gekühlten Innenluftstrom (26) und der Ansaugraum (20) für den im Wärmeübertrager (5) erwärmten Außenluftstrom (17) etwa gleich groß ausgebildet und in ein Gehäuse (12) des Wärmeübertragers (5) integriert sind.

9. Geräteschrank nach einem der Ansprüche 1 bis 6,
**dadurch gekennzeichnet,**
**dass** der Wärmetauscher (4) ein Seitenanbau-Wärmetauscher (32) oder ein Seiteneinbau-Wärmetauscher (34) ist, welcher einen Wärmeübertrager (5) mit vertikal ausgerichteten Innenluft- und Außenluftkanälen und mit Radiallüftern (18, 19) für den Innenluftstrom (6) und Außenluftstrom (7) aufweist, wobei der Radiallüfter (18) für den Innenluftstrom (6) unter Ausbildung eines Ansaugraums (10) bodenseitig und der Radiallüfter (19) für den Außenluftstrom (7) unter Ausbildung eines Ansaugraums (20) deckenseitig derart angeordnet sind, dass die verlängert gedachten Lüfterachsen (28, 29) der Radiallüfter (18, 19) auf einer Achse und parallel zu den Innen- und Außenluftkanälen des Wärmeübertragers (5) ausgerichtet sind. (Fig. 7 bis 12)

10. Geräteschrank nach Anspruch 9,
**dadurch gekennzeichnet,**
**dass** der Wärmetauscher (4) als Seitenanbau-Wärmetauscher (32) oder Seiteneinbau-Wärmetauscher (34) ein Gehäuse (22) aufweist, in dessen oberen Bereich der Wärmeübertrager (5) angeordnet ist und dass der Ansaugraum (10) für den gekühlten Innenluftstrom (26), welcher vom bodenseitig und unterhalb des Wärmeübertragers (5) angeordneten Radiallüfter (18) angesaugt wird, wesentlich größer dimensioniert ist als der Ansaugraum (20) für den erwärmten Außenluftstrom (17), welcher oberhalb des Wärmeübertragers (5) ausgebildet ist. (Fig. 7 bis 12)

11. Geräteschrank nach einem der Ansprüche 1 bis 6,
**dadurch gekennzeichnet,**
**dass** der Wärmetauscher (4) in einer Tür oder einer Rückwand des Geräteschrankes (2) angeordnet ist.

## Claims

1. Equipment cabinet,
having a receiving area (3) for electronic components and having a heat exchanger (4) which has a heat transferor (5) with duct plates arranged parallel to each other to form ducts for an internal air flow (6) and an external air flow (7) as well as a blower (8) for the internal air flow (6) and a blower (9) for the external air flow (7), wherein the internal air flow (6) is conveyed with the aid of the internal air blower (8) in the circuit through the receiving area (3) and the heat exchanger (4), and the heated internal air flow (16) which is impinged with the dissipated heat of the electronic components can be de-heated in the heat transferor (5) by the external air flow (7) and be fed back to the receiving area (3) as cooled internal air flow (26),
wherein the blower (8) for the internal air flow (6) is a radial fan (18) which is arranged and dimensioned, in relation to the direction of the internal air flow (6), after the heat transferor (5) and with its suction side spaced apart from the heat transferor (5) in such a way that a suction chamber (10) is formed between the heat transferor (5) and the radial fan (18) for a uniform negative pressure in the internal air ducts of the heat transferor (5),
**characterised in that**
the radial fan (18) for the internal air flow (6) is arranged with its fan axis (28) in the suction direction and with a notional extension of the fan axis (28) parallel to the longitudinal axes of the internal air ducts of the heat transferor (5).

2. Equipment cabinet according to claim 1,
**characterised in that**
the suction chamber (10) for the cooled internal air flow (26) is bounded on the side of the heat transferor (5) by an exit plane (15) of the cooled internal air flow (26) from the heat transferor (5) and on the fan side by a suction nozzle (11) of the radial fan (18).

3. Equipment cabinet according to one of claims 1 or 2,
**characterised in that**
the suction chamber (10) for the cooled internal air flow (26) is integrated into a housing (12) of the heat exchanger (4), in which the radial fan (18) for the internal air flow (6) can also be arranged.

4. Equipment cabinet according to one of the preceding claims,
**characterised in that**
the blower (9) for the external air flow (7) is a radial fan (19) which is arranged, in relation to the direction of the external air flow (7), after the heat transferor (5) and between the heat transferor (5) and the suction side of the radial fan (19), thereby forming a suction chamber (20) for the external air flow (17) heated in the heat transferor (5).

5. Equipment cabinet according to claim 4,
**characterised in that**
the radial fan (19) for the external air flow (7) is arranged with its fan axis (29) in the suction direction and with a notional extension of the fan axis (29) parallel to the longitudinal axes of the external air ducts of the heat transferor (5).

6. Equipment cabinet according to claim 4 or 5,
**characterised in that**
the suction chamber (20) for the external air flow (17) heated in the heat transferor (5) is bounded on the side of the heat transferor (5) by an exit plane of the external air (17) heated in the heat transferor (5) and on the fan side by a suction nozzle (13) of the radial fan (19).

7. Equipment cabinet according to one of the preceding claims,
**characterised in that**
the heat exchanger (4) is a roof heat exchanger with a heat transferor (5) which has horizontally arranged internal air and external air ducts, and also with radial fans (18, 19) for the internal air flow (6) and for the external air flow (7) which are arranged respectively spaced apart from the heat transferor (5) in side regions, lying opposite each another, of the equipment cabinet (2) or in side regions of the roof of the equipment cabinet (2), thereby forming a suction chamber (10) for the internal air flow (26) cooled in the heat transferor (5) and a suction chamber (20) for the external air flow (17) heated in the heat transferor (5). (Figs. 1 to 4)

8. Equipment cabinet according to claim 7,
**characterised in that**
the suction chamber (10) for the internal air flow (26) cooled in the heat transferor (5) and the suction chamber (20) for the external air flow (17) heated in the heat transferor (5) are designed to be approximately the same size and are integrated into a housing (12) of the heat transferor (5).

9. Equipment cabinet according to one of claims 1 to 6,
**characterised in that**
the heat exchanger (4) is a side add-on heat exchanger (32) or a side incorporated heat exchanger (34) which has a heat transferor (5) with vertically orientated internal air and external air ducts and with radial fans (18, 19) for the internal air flow (6) and external air flow (7), wherein the radial fan (18) for the internal air flow (6) is arranged at the bottom side, thereby forming a suction chamber (10), and the radial fan (19) for the external air flow (7) is arranged on the cover side, thereby forming a suction chamber (20) for the external air flow (7), in such a way that the notional extended fan axes (28, 29) of the radial fans (18, 19) are orientated on an axis and parallel to the internal and external air ducts of the heat transferor (5). (Figs. 7 to 12)

10. Equipment cabinet according to claim 9,
**characterised in that**
the heat exchanger (4), as a side add-on heat exchanger (32) or side incorporated heat exchanger (34), has a housing (22), in the upper region of which the heat transferor (5) is arranged, and the suction chamber (10) for the cooled internal air flow (26), which is drawn in by the radial fan (18) arranged on the bottom side and below the heat transferor (5), has substantially larger dimensions than the suction chamber (20) for the heated external air flow (17) which is formed above the heat transferor (5). (Figs. 7 to 12)

11. Equipment cabinet according to one of claims 1 to 6,
**characterised in that**
the heat exchanger (4) is arranged in a door or a rear wall of the equipment cabinet (2).

## Revendications

1. Armoire d'appareil
avec un espace de réception (3) pour des composants électroniques et avec un échangeur thermique (4), lequel présente un transmetteur thermique (5) avec des plaques à conduits disposées parallèlement les unes aux autres pour former des conduits pour un flux d'air interne (6) et un flux d'air externe (7) ainsi qu'un ventilateur (8) pour le flux d'air interne (6) et un ventilateur (9) pour le flux d'air externe (7), tandis que le flux d'air interne (6) est conduit à l'aide du ventilateur d'air interne (8) dans le circuit via l'espace de réception (3) et l'échangeur thermique (4) et que le flux d'air interne réchauffé (16) et alimenté par la chaleur perdue des composants électroniques peut être refroidi dans le transmetteur thermique (5) via le flux d'air externe (7) et reconduit, en tant que flux d'air interne refroidi (26), dans l'espace de réception (3),
tandis que le ventilateur (8) pour le flux d'air interne (6) est un ventilateur radial (18), lequel, appliqué à la direction du flux d'air interne (6), est disposé et dimensionné par rapport au transmetteur thermique (5) et se trouve, avec son côté d'aspiration, à une certaine distance du transmetteur thermique (5), de sorte qu'entre le transmetteur thermique (5) et le ventilateur radial (18), un espace d'aspiration (10) soit formé pour une dépression égale dans les conduits d'air interne du transmetteur thermique (5),
**caractérisée en ce que**
le ventilateur radial (18) est disposé pour le flux d'air interne (6) avec son axe de ventilateur (28) dans la direction d'aspiration et avec un prolongement imaginaire de l'axe de ventilateur (28) parallèlement aux axes longitudinaux des conduits d'air interne du transmetteur thermique (5).

2. Armoire d'appareil selon la revendication 1
**caractérisée en ce que**
l'espace d'aspiration (10) pour le flux d'air interne refroidi (26) du côté du transmetteur thermique (5) est limité par un plan de sortie (15) du flux d'air interne refroidi (26) à partir du transmetteur thermique (5) et, du côté du ventilateur, par une buse d'aspiration (11) du ventilateur radial (18).

3. Armoire d'appareil selon les revendications 1 ou 2
**caractérisée en ce que**
l'espace d'aspiration (10) pour le flux d'air interne refroidi (26) est intégré dans un boîtier (12) de l'échangeur thermique (4), dans lequel également le ventilateur radial (18) pour le flux d'air interne (6) peut être disposé.

4. Armoire d'appareil selon l'une des revendications précédentes
**caractérisée en ce que**
le ventilateur (9) pour le flux d'air externe (7) est un ventilateur radial (19), lequel, appliqué à la direction du flux d'air externe (7), est disposé par rapport au transmetteur thermique (5), avec formation un espace d'aspiration (20) pour le flux d'air externe réchauffé (17) dans le transmetteur thermique (5) entre le transmetteur thermique (5) et le côté d'aspiration du ventilateur radial (19).

5. Armoire d'appareil selon la revendication 4
**caractérisée en ce que**
le ventilateur radial (19) pour le flux d'air externe (7) est disposé avec son axe de ventilateur (29) dans la direction d'aspiration et avec un prolongement imaginaire de l'axe de ventilateur (29) parallèlement à l'axe longitudinal des conduits d'air externe du transmetteur thermique (5).

6. Armoire d'appareil selon les revendications 4 ou 5
**caractérisée en ce que**
l'espace d'aspiration (20) pour le flux d'air externe réchauffé (17) dans le transmetteur thermique (5) du côté du transmetteur thermique (5) est limité par un plan de sortie de l'air externe réchauffé (17) dans le transmetteur thermique (5) et, du côté du ventilateur, par une buse d'aspiration (13) du ventilateur radial (19).

7. Armoire d'appareil selon une des revendications précédentes
**caractérisée en ce que**
l'échangeur thermique (4) est un échangeur thermique de toit avec un transmetteur thermique (5), qui présente des conduits d'air interne et d'air externe disposés horizontalement, et avec des ventilateurs radiaux (18, 19) pour le flux d'air interne (6) et pour le flux d'air externe (7), lesquels sont disposés dans des zones latérales opposées de l'armoire d'appareil (2) ou dans des zones latérales du toit de l'armoire d'appareil (2), avec formation d'un espace d'aspiration (10) pour le flux d'air interne refroidi (26) dans le transmetteur thermique (5) et d'un espace d'aspiration (20) pour le flux d'air externe réchauffé (17) dans le transmetteur thermique (5), chacun étant situé à une certaine distance du transmetteur thermique (5). (fig. 1 à 4)

8. Armoire d'appareil selon la revendication 7
**caractérisée en ce que**
l'espace d'aspiration (10) pour le flux d'air interne refroidi (26) dans le transmetteur thermique (5) et l'espace d'aspiration (20) pour le flux d'air externe réchauffé (17) dans le transmetteur thermique (5) ont à peu près la même taille et sont intégrés dans un boîtier (12) du transmetteur thermique (5).

9. Armoire d'appareil selon les revendications 1 à 6
**caractérisée en ce que**
l'échangeur thermique (4) est un échangeur thermique de montage latéral (32) ou un échangeur thermique d'encastrement latéral (34), qui présente un transmetteur thermique (5) avec des conduits d'air interne et d'air externe orientés verticalement et avec des ventilateurs radiaux (18, 19) pour le flux d'air interne (6) et le flux d'air externe (7), tandis que le ventilateur radial (18) pour le flux d'air interne (6), avec formation d'un espace d'aspiration (10) côté fond, et le ventilateur radial (19) pour le flux d'air externe (7), avec formation d'un espace d'aspiration (20) côté plafond, sont disposés de telle sorte que les axes de ventilateur imaginaires prolongés (28, 29) des ventilateurs radiaux (18, 19) sont orientés sur un axe et parallèlement aux conduits d'air interne et externe du transmetteur thermique (5). (fig. 7 à 12)

10. Armoire d'appareil selon la revendication 9
**caractérisée en ce que**
l'échangeur thermique (4), en tant qu'échangeur thermique de montage latéral (32) ou échangeur thermique d'encastrement latéral (34), présente un boîtier (22), dans la partie haute duquel est disposé le transmetteur thermique (5) et **en ce que** l'espace d'aspiration (10) pour le flux d'air interne refroidi (26), lequel est aspiré par le ventilateur radial (18) disposé côté fond et sous le transmetteur thermique (5), a des dimensions considérablement plus grandes que l'espace d'aspiration (20) pour le flux d'air externe réchauffé (17), lequel est formé au-dessus du transmetteur thermique (5). (fig. 7 à 12)

11. Armoire d'appareil selon les revendications 1 à 6
**caractérisée en ce que**
l'échangeur thermique (4) est disposé dans une porte ou une paroi arrière de l'armoire d'appareil (2).
